(19) Europäisches Patentamt / European Patent Office / Office européen des brevets

(11) **EP 4 278 374 B1**

(12) **FASCICULE DE BREVET EUROPEEN**

(45) Date de publication et mention de la délivrance du brevet:
**16.04.2025 Bulletin 2025/16**

(21) Numéro de dépôt: **21852055.9**

(22) Date de dépôt: **23.12.2021**

(51) Classification Internationale des Brevets (IPC):
***H01L 21/02*** *(2006.01)*

(52) Classification Coopérative des Brevets (CPC):
**H01L 21/02002**

(86) Numéro de dépôt international:
**PCT/FR2021/052443**

(87) Numéro de publication internationale:
**WO 2022/152990 (21.07.2022 Gazette 2022/29)**

(54) **SUBSTRAT SUPPORT EN SILICIUM ADAPTE AUX APPLICATIONS RADIOFREQUENCES ET PROCEDE DE FABRICATION ASSOCIE**

TRÄGERSUBSTRAT AUS SILIZIUM FÜR HOCHFREQUENZANWENDUNGEN UND ZUGEHÖRIGES HERSTELLUNGSVERFAHREN

SUPPORT SUBSTRATE MADE OF SILICON SUITABLE FOR RADIOFREQUENCY APPLICATIONS AND ASSOCIATED MANUFACTURING METHOD

(84) Etats contractants désignés:
AL AT BE BG CH CY CZ DE DK EE ES FI FR GB GR HR HU IE IS IT LI LT LU LV MC MK MT NL NO PL PT RO RS SE SI SK SM TR

(30) Priorité: **15.01.2021 FR 2100371**

(43) Date de publication de la demande:
**22.11.2023 Bulletin 2023/47**

(73) Titulaires:
• **Applied Materials, Inc.**
**Santa Clara, California 95054 (US)**
• **SOITEC**
**38190 Bernin (FR)**

(72) Inventeurs:
• **KONONCHUCK, Oleg**
**38190 Bernin (FR)**
• **MALEVILLE, Christophe**
**38190 Bernin (FR)**
• **BERTRAND, Isabelle**
**38190 Bernin (FR)**
• **KIM, Youngpil**
**38190 Bernin (FR)**
• **WONG, Chee Hoe**
**38190 Bernin (FR)**

(74) Mandataire: **IP Trust**
**2, rue de Clichy**
**75009 Paris (FR)**

(56) Documents cités:
US-A1- 2019 115 248     US-A1- 2020 126 847
US-A1- 2020 266 099

**Description**

## DOMAINE DE L'INVENTION

La présente invention vise le domaine des semi-conducteurs et de la microélectronique. Elle concerne un substrat support en silicium adapté pour les applications radiofréquences, et destiné à supporter des couches minces, en particulier pour former une structure Silicium sur Isolant (SOI). L'invention concerne également un procédé de fabrication d'un tel substrat support.

## ARRIERE PLAN TECHNOLOGIQUE DE L'INVENTION

Les structures SOI (Silicium sur Isolant) sont largement utilisées pour les applications radiofréquences (RF).

On connaît en particulier les structures SOI comprenant un substrat de base, une couche de piégeage de charges disposée sur ledit substrat, une couche diélectrique disposée sur la couche de piégeage, et une couche de semi-conducteur (la couche utile destinée à accueillir les dispositifs RF) disposée sur la couche diélectrique. Le substrat de base en silicium monocristallin présente habituellement une résistivité supérieure à 3 kOhm.cm et une faible teneur en oxygène interstitiel (Oi < 10ppma ASTM'79). La couche de piégeage comprend du silicium poly-cristallin non dopé, présentant une épaisseur de l'ordre de 2 microns. La combinaison d'un substrat de base en silicium haute résistivité et d'une couche de piégeage permet d'éliminer la couche de conduction parasite présente habituellement sous la couche d'oxyde enterré dans les substrats SOI HR (silicium sur isolant avec substrat support en silicium haute résistivité). L'homme du métier trouvera une revue des performances des dispositifs RF fabriqués sur un substrat semi-conducteur haute résistivité connu de l'état de la technique dans « Silicon-on-insulator (SOI) Technology, manufacture and applications », points 10.7 et 10.8, Oleg Kononchuk et Bich-Yen Nguyen, chez Woodhead Publishing.

Une structure SOI avec un substrat de base à faible teneur en oxygène interstitiel tel que précité est stable électriquement et confère donc de bonnes performances aux dispositifs RF élaborés sur ou dans la couche utile (à savoir, de faibles pertes d'insertion correspondant à une faible atténuation du signal, et une bonne linéarité correspondant à une faible distorsion du signal à l'origine d'harmoniques). Néanmoins, il présente une tenue mécanique moindre : en effet, il est susceptible de déclencher des défauts de type lignes de glissement (« slip lines » selon la terminologie anglo-saxonne), lorsque des traitements thermiques à hautes températures lui sont appliqués, ce qui amène des pertes de rendement.

Une autre option consiste à mettre en œuvre un substrat de base présentant une résistivité standard de l'ordre de 10-20 ohm.cm et une teneur moyenne en oxygène interstitiel (13-19ppma ASTM'79). La couche de piégeage en silicium poly-cristallin non dopé présente alors une épaisseur supérieure à 20 microns, pour garantir le caractère hautement résistif du substrat. Une telle structure présente une bonne stabilité électrique et mécanique, mais souffre d'une importante courbure (« bow / warp ») liée à la contrainte dans la couche épaisse de piégeage ; cela peut complexifier son traitement dans une ligne de fabrication microélectronique. Cette structure présente également l'inconvénient de requérir un dépôt épais et un polissage long de la couche de piégeage, ce qui augmente significativement les coûts de fabrication.

Le document US2018114720 propose une autre structure SOI basée sur la croissance épitaxiale d'une couche en silicium sur un substrat de base en silicium monocristallin : le substrat de base présente une résistivité supérieure à 500 ohm.cm et la couche épitaxiée présente une résistivité comprise entre 100 et 5000 ohm.cm. La couche de piégeage en silicium poly-cristallin est déposée sur la couche épitaxiée, et les couches d'oxyde et de silicium de la structure SOI sont disposées sur la couche de piégeage. Selon un mode de réalisation, la couche épitaxiée comprend une concentration de dopants actifs de type N, inférieure à 1E14 atomes/cm$^3$, lesdits dopants étant du type opposé à celui des dopants du substrat de base, de sorte que la couche épitaxiée présente une zone déplétée de très haute résistivité, ce qui améliore les performances des dispositifs radiofréquences élaborés sur la structure.

Il demeure néanmoins encore le besoin d'optimiser les propriétés mécaniques et électriques des structures SOI, pour répondre aux exigences des différentes applications RF dans une juste mesure et conserver des coûts raisonnables. US 2020/0126847 A1 décrit un substrat support pour applications radiofréquences comprenant un substrat de base en silicium monocristallin dopé, une couche épitaxiée en silicium monocristallin, et une couche de piégeage de charges en silicium polycristallin.

## OBJET DE L'INVENTION

La présente invention propose une solution adressant en tout ou partie les inconvénients et problématiques précitées. Elle concerne en particulier un substrat support adapté à des applications RF et susceptible de supporter des couches superficielles, sur et/ou dans lesquelles des dispositifs microélectroniques seront élaborés. L'invention concerne également un procédé de fabrication dudit substrat support.

## BREVE DESCRIPTION DE L'INVENTION

La présente invention concerne un substrat support pour une application radiofréquence comprenant :

- un substrat de base en silicium monocristallin comprenant des dopants de type P et présentant une résistivité supérieure ou égale à 250 ohm.cm et strictement inférieure à 500 ohm.cm, et une teneur en oxygène interstitiel comprise entre 13 ppma et 19 ppma selon la norme ASTM'79,
- une couche épitaxiée en silicium monocristallin comprenant des dopants de type P, disposée sur le substrat de base et présentant une épaisseur comprise entre 2 microns et 30 microns, une portion supérieure au moins de la couche épitaxiée présentant une résistivité supérieure ou égale à 3000 ohm.cm,
- une couche de piégeage de charges en silicium polycristallin présentant une résistivité supérieure ou égale à 1000 ohm.cm et une épaisseur comprise entre 1 micron et 10 microns.

Selon des caractéristiques avantageuses de l'invention, prises seules ou selon toute combinaison réalisable :

- la résistivité du substrat de base est inférieure ou égale à 450 ohm.cm ;
- la couche épitaxiée présente une épaisseur comprise entre 2 microns et 20 microns ;
- le substrat support comprend au moins une interface rugueuse entre le substrat de base et la couche épitaxiée, et/ou entre la couche épitaxiée et la couche de piégeage de charges ;
- l'épaisseur de la couche épitaxiée est définie en fonction de l'épaisseur de la couche de piégeage et en fonction d'une valeur maximale de distorsion de deuxième harmonique visée pour l'application radiofréquence, suivant des abaques établis pour un facteur de qualité représentatif de la distorsion de deuxième harmonique.

L'invention concerne également une structure silicium sur isolant comprenant une couche utile disposée sur une couche diélectrique, elle-même disposée sur un substrat support tel que ci-dessus.

Elle concerne en outre un dispositif électronique pour application radiofréquence comprenant au moins un transistor disposé sur et/ou dans la couche utile d'une structure silicium sur isolant telle que précitée.

L'invention concerne enfin un procédé de fabrication d'un substrat support tel que ci-dessus, le procédé de fabrication comprenant les étapes suivantes :

a) la fourniture du substrat de base,
b) la croissance par épitaxie d'une couche en silicium monocristallin sur le substrat de base, pour former la couche épitaxiée,
c) le dépôt de la couche de piégeage de charges sur la couche épitaxiée.

Selon des caractéristiques avantageuses de l'invention, prises seules ou selon toute combinaison réalisable :

- le substrat de base fourni à l'étape a) présente une rugosité de surface supérieure à 10nm RMS, voire supérieure à 100nm RMS, voire supérieure à 1 micron RMS ;
- l'étape c) est suivie d'un polissage mécano-chimique de la couche de piégeage de charges, de manière à obtenir une rugosité de surface du substrat support inférieure ou égale à 1nm, du côté de sa face avant ;
- les étapes b) et c) sont réalisées in situ, dans un même équipement, une couche d'oxyde de silicium étant déposée sur la couche épitaxiée préalablement au dépôt de la couche de piégeage de charges ;
- le procédé comprend une séquence de conception préalablement à l'étape a) ou à l'étape b) comportant :

i) la définition de la valeur maximale de distorsion de deuxième harmonique visée pour l'application radiofréquence,
ii) le choix de l'épaisseur de la couche épitaxiée et de la résistivité du substrat de base, à partir d'abaques reliant un facteur de qualité, représentatif de la distorsion de deuxième harmonique, à l'épaisseur de la couche épitaxiée, pour une résistivité donnée du substrat de base et pour une épaisseur donnée de la couche de piégeage.

## BREVE DESCRIPTION DES DESSINS

D'autres caractéristiques et avantages de l'invention ressortiront de la description détaillée qui va suivre en référence aux figures annexées sur lesquelles :

[Fig. 1] La figure 1 présente un substrat support conforme à l'invention ;

[Fig. 2] La figure 2 présente une structure silicium sur isolant comprenant un substrat support, conforme à l'invention ;

[Fig.3] La figure 3 présente des courbes reliant la résistivité initiale et la résistivité après un recuit à 450°C pendant 1h d'un substrat de base ;

[Fig.4] La figure 4 présente une corrélation entre le facteur de qualité QF et un paramètre HD2 de distorsion d'harmonique du second ordre ou distorsion de deuxième harmonique ;

[Fig.5] La figure 5 présente un profil de résistivité en profondeur mesuré par SRP, d'un substrat support conforme à l'invention ;

[Fig.6] La figure 6 présente un abaque reliant le facteur de qualité QF et l'épaisseur de la couche épitaxiée pour un substrat support conforme à l'invention (a) et pour un substrat hors de l'invention (b).

Certaines figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y.

## DESCRIPTION DETAILLEE DE L'INVENTION

L'invention concerne un substrat support 10 en silicium monocristallin, présentant une face avant 10a et une face arrière 10b, sensiblement parallèles à un plan principal (x,y). Il se présente avantageusement sous la forme d'une plaquette de forme circulaire, de diamètre compris entre 200mm et 450mm. Son épaisseur totale, selon l'axe z normal au plan principal (x,y), peut typiquement varier entre quelques centaines de microns et 1000 microns.

Le substrat support 10 comprend un substrat de base 1 en silicium monocristallin issu d'un tirage de lingot de type Czochralski (CZ). Il présente une résistivité comprise dans une plage spécifique restreinte, à savoir supérieure ou égale à 250 ohm.cm et strictement inférieure à 500 ohm.cm. Avantageusement, la résistivité du substrat de base 1 est comprise entre 250 ohm.cm et 450 ohm.cm. Le substrat de base 1 comprend des dopants de type P (bore), en faible concentration pour obtenir une résistivité dans la plage précitée.

Il présente en outre une teneur en oxygène interstitiel (Oi) comprise entre 13 ppma et 19 ppma, correspondant à une teneur basse à moyenne en Oi. Notons que l'unité ppma utilisée ici et dans la suite de cette description, fait référence à la norme ASTM'79. La plage de teneur en Oi correspond à une concentration en Oi comprise entre $6.5E17$ Oi/cm$^3$ et $9.5E17$ Oi/cm$^3$.

Le substrat support 10 comprend également, du côté de sa face avant 10a, une couche épitaxiée 2 en silicium monocristallin comprenant des dopants de type P (bore), disposée sur le substrat de base 1. La couche épitaxiée 2 présente une portion inférieure du côté du substrat de base 1 et partageant une interface avec ce dernier, et une portion supérieure. La portion supérieure au moins de la couche épitaxiée 2 présente une résistivité supérieure ou égale à 3000 ohm.cm : sa résistivité peut par exemple être de 4000 ohm.cm, 5000 ohm.cm, 8000 ohm.cm, 10 kohm.cm, voire au-delà.

La couche épitaxiée 2 présente une épaisseur comprise entre 2 microns et 30 microns. Avantageusement, et essentiellement pour des questions de coûts, son épaisseur est comprise entre 2 et 20 microns.

La couche 2 est élaborée par croissance épitaxiale, sur le substrat de base 1. Du fait de son procédé d'élaboration, la couche épitaxiée 2 comprend une très faible teneur en oxygène interstitiel et présente ainsi une excellente stabilité électrique : typiquement, elle est très peu sensible aux fluctuations de résistivité en fonction des traitements thermiques appliqués au substrat support 10.

Enfin, le substrat support 10 comporte une couche de piégeage de charges 3 en silicium poly-cristallin présentant une résistivité supérieure ou égale à 1000 ohm.cm, avantageusement supérieure ou égale à 5000 ohm.cm. La couche de piégeage 3 présente une épaisseur comprise entre 1 micron et 10 microns.

Pour permettre l'élaboration de dispositifs électroniques, une couche utile, sur ou dans laquelle se situeront lesdits dispositifs, peut être reportée sur le substrat support 10.

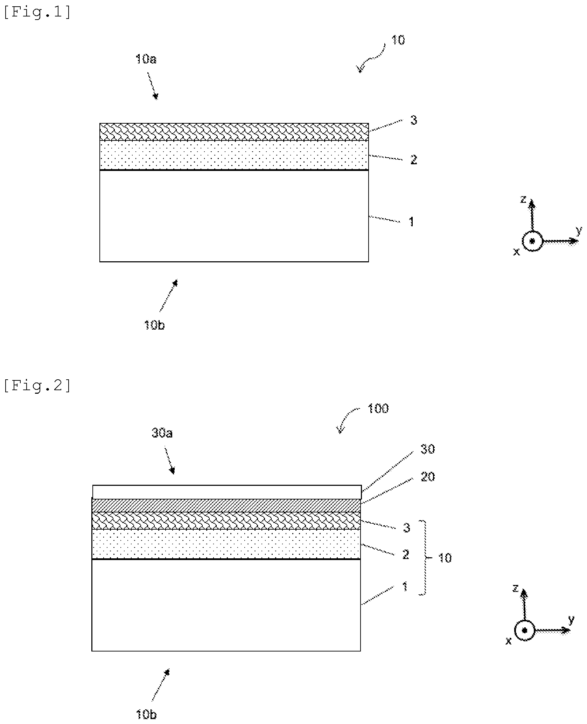

L'invention concerne donc également une structure Silicium sur Isolant (SOI) 100 comprenant une couche utile 30 disposée sur une couche diélectrique 20, elle-même disposée sur un substrat support 10 précité (figure 2).

La couche utile 30 est en silicium monocristallin de haute qualité et présente une épaisseur typiquement comprise entre 20 nm et 200 nm. La couche diélectrique 20, par exemple en oxyde de silicium, peut présenter quant à elle une épaisseur comprise entre 100 nm et 2000 nm.

L'élaboration de la structure SOI 100 est préférentiellement basée sur le procédé de transfert de couches minces connu sous l'appellation procédé Smart Cut™ et brièvement rappelé ci-après. Un substrat donneur en silicium monocristallin est implanté par sa face avant, de manière à définir un plan fragile enterré sensiblement parallèle à la face avant et délimitant, avec cette dernière, la couche mince à reporter. L'implantation est habituellement faite avec des espèces légères telles que des ions d'hydrogène, d'hélium ou une combinaison de ces deux espèces. Le plan fragile est ainsi nommé car il comprend des nano-fissures sous forme lenticulaire générées par les espèces légères implantées.

Selon une option préférentielle, la couche mince à reporter comprend, de la face avant du substrat donneur jusqu'au plan fragile enterré, une couche diélectrique 20 et une couche en silicium 30, lesquelles formeront respectivement la couche diélectrique enterrée 20 et la couche utile 30 en silicium de la structure SOI 100. On comprendra donc que l'énergie d'implantation des espèces légères est choisie et ajustée de manière à former le plan fragile enterré (plus ou moins localisé au niveau du pic d'implantation) à la profondeur correspondant à l'épaisseur souhaitée de couche utile 30, en tenant compte d'étapes de finition (évoquées ci-après) qui consomment une partie de matière de ladite couche 30.

Le substrat donneur et le substrat support 10 sont ensuite assemblés, par collage direct entre les faces avant desdits substrats, pour former un ensemble collé. Des nettoyages et/ou activations de surface, bien connus dans le domaine du collage par adhésion moléculaire, pourront être appliqués aux substrats préalablement à l'assemblage, pour obtenir une excellente qualité de collage. Un assemblage en atmosphère contrôlée est également possible.

La séparation au niveau du plan fragile enterré s'effectue préférentiellement par application d'un traitement thermique à température moyenne, typiquement entre 350°C et 500°C, du fait de la croissance de microfissures par coalescence et par mise sous pression des espèces gazeuses. Alternativement ou conjointement, la séparation peut être provoquée par l'application d'une contrainte mécanique à l'ensemble collé.

A l'issue de cette séparation, on obtient une structure SOI intermédiaire d'une part, et le reste du substrat donneur, d'autre part. Des séquences de finition comprenant des nettoyages, des traitements de surface (gravure, polissage, etc.) et/ou des traitements thermiques sont habituellement appliquées à la structure SOI intermédiaire, et visent à retirer une partie de matière de la couche utile 30 reportée. Cela permet de restaurer un bon état de surface (défectivité et rugosité) et une bonne qualité cristalline à la couche utile 30 en silicium. A la suite de quoi, la structure SOI 100 est disponible.

Les traitements thermiques de finition précités sont habituellement opérés à des températures comprises entre 900°C et 1250°C : la robustesse du substrat de base 1 aux défauts de type lignes de glissement (« slip lines ») et autres déformations plastiques, est un atout significatif lors de ces traitements et permet de conserver une très bonne intégrité de la structure SOI 100.

Bien que l'élaboration de la structure SOI 100 ait été décrite ici en référence au procédé Smart Cut™, une telle structure peut également être réalisée à partir d'autres procédés de transfert de couches minces connus de l'état de la technique.

L'invention concerne également un dispositif électronique pour les applications radiofréquences. Un tel dispositif peut comprendre en particulier, au moins un transistor disposé sur la face 30a de la couche utile et/ou dans la couche utile 30 de la structure SOI 100 et élaboré selon une technologie CMOS (« complementary metal oxide semiconductor » pour métal - oxyde - semi-conducteur complémentaire).

Les dispositifs électroniques peuvent notamment consister en des commutateurs RF (« switch »), des amplificateurs de puissance (« power amplifier PA »), des amplificateurs faible bruit (« low noise amplifier LNA »), des émetteurs/récepteurs, etc.

La sélection très particulière d'une résistivité comprise dans la plage [250 ohm.cm inclus ; 500 ohm.cm exclu] pour le substrat de base 1 du substrat support 10 est ainsi faite pour procurer à la fois une bonne stabilité électrique et une bonne stabilité mécanique au substrat support 10. En effet, la demanderesse a observé qu'à 500 ohm.cm et au-delà, il existe un risque majeur de changement de type (« type flipping » selon la terminologie anglo-saxonne) du substrat de base 1, lorsque des recuits à basses températures sont appliqués (habituellement, les recuits de passivation dans les procédés de fabrication des dispositifs microélectroniques). Ce changement de type est très dommageable pour la performance RF des dispositifs élaborés sur ou dans la couche utile 30 disposée sur le substrat support 10.

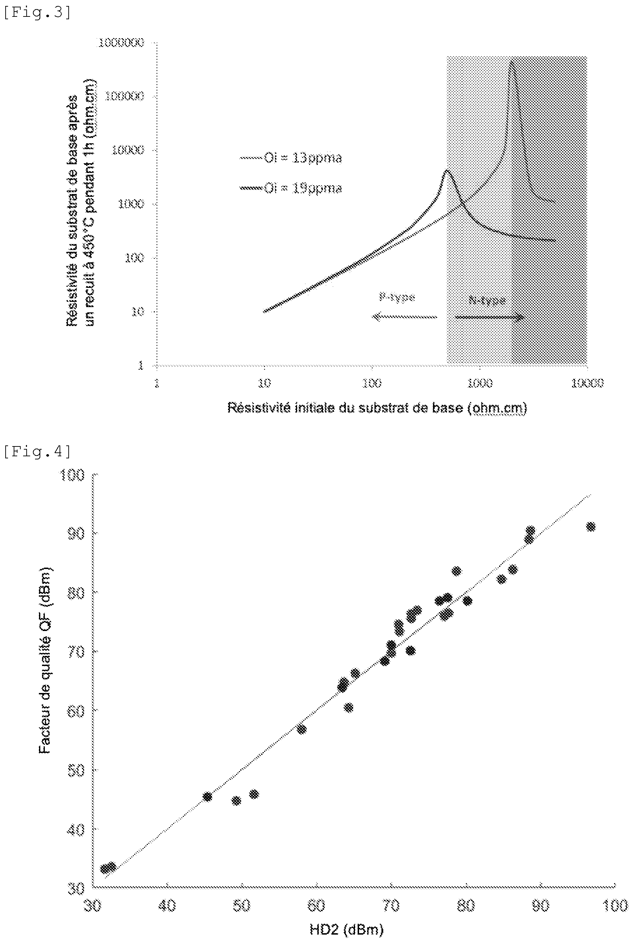

La figure 3 illustre deux courbes représentant la résistivité du substrat de base 1 après qu'un recuit à 450°C pendant 1h lui soit appliqué, en fonction de la résistivité initiale dudit substrat 1 ; la première courbe est établie pour une teneur en Oi du substrat de base 1 de 13 ppma, la deuxième pour une teneur en Oi de 19 ppma. On remarque un comportement identique avec un pic correspondant au basculement du type P au type N du substrat de base 1, du fait de la génération de donneurs thermiques liés à l'oxygène interstitiel Oi. Le pic pour la plus faible teneur en Oi est néanmoins sensiblement décalé vers les plus hautes résistivités initiales. Pour prendre en compte les incertitudes sur les caractéristiques du substrat de base 1 et sur les procédés d'élaboration des dispositifs (durée et température du recuit, habituellement opéré autour de 450°C), la demanderesse a défini une borne maximale (exclue) de résistivité initiale à 500 ohm.cm pour le substrat de base 1. Le substrat de base 1 ne peut ainsi pas subir de changement de type au cours du recuit de passivation, à basse température, habituellement appliqué dans les étapes finales de fabrication des dispositifs microélectroniques. Il conserve donc de façon stable et reproductible sa résistivité initiale. La borne inférieure est fixée à 250 ohm.cm car il est nécessaire de demeurer résistif pour favoriser la performance RF des futurs dispositifs et pour faciliter l'élaboration des substrats de base 1 (meilleur rendement lors du tirage des lingots).

De plus, la teneur moyenne en Oi du substrat de base 1 permet de diminuer grandement la sensibilité du substrat support 10 aux lignes de glissement. Des traitements thermiques à hautes températures peuvent ainsi être appliqués avec plus de flexibilité.

La couche épitaxiée 2, dont l'épaisseur est ajustable en fonction des spécifications de l'application RF, entre 2 microns et 30 microns, conserve un niveau de résistivité très élevé quels que soient les traitements thermiques appliqués au substrat support 10, ce qui est favorable aux performances RF des dispositifs électroniques élaborés au-dessus.

Enfin, la couche de piégeage 3 remplit son rôle de piégeage des charges générées en dessous de la couche diélectrique 20 de la structure SOI 100. Des charges ne viennent donc pas dégrader la haute résistivité de la couche épitaxiée 2.

La présente invention concerne enfin un procédé de fabrication d'un substrat support 10 tel que décrit précédemment.

Le procédé de fabrication comprend une étape a) de fourniture du substrat de base 1. Ce dernier est habituellement élaboré par sciage du lingot CZ, puis par rectification des faces et des bords du substrat, par gravure chimique et enfin par polissage mécano-chimique pour aboutir à une qualité et une rugosité de surface, habituelle dans le domaine de la microélectronique, à savoir inférieure à 1 nm RMS au niveau de sa face avant. La rugosité RMS est typiquement mesurée par microscopie à force atomique (AFM) sur une surface balayée de 5x5 microns ou 20x20 microns.

Selon une variante de réalisation du procédé, le substrat de base 1 peut présenter une rugosité en face avant supérieure à 10nm RMS, voire supérieure à 100nm RMS, voire encore supérieure à 1 micron RMS. Selon cette variante, tout ou partie des séquences de polissage mécano-chimique habituellement appliquées au substrat de base 1 peut être évité, ce qui présente un fort intérêt industriel.

Le procédé comprend ensuite une étape b) de croissance par épitaxie d'une couche en silicium monocristallin sur le substrat de base 1, pour former la couche épitaxiée 2.

La croissance par épitaxie est opérée avec un procédé classique, typiquement à une température comprise entre 1050°C et 1150°C dans une atmosphère comprenant de l'hydrogène et du trichlorosilane ($H_2$/$HCl_3Si$). Comme cela est bien connu, le substrat de base 1 est préparé préalablement à l'épitaxie, de manière à éliminer un maximum de contaminations de surface (organique, métalliques, dopants...) et à retirer l'oxyde natif : cela afin de générer une couche épitaxiée 2 de structure monocristalline.

Il n'est néanmoins pas attendu une haute qualité monocristalline de la couche épitaxiée 2, c'est la raison pour laquelle la variante de réalisation susmentionnée utilisant un substrat de base 1 rugueux peut être mise en œuvre sans impact négatif. Les paramètres importants de la couche épitaxiée ont déjà été énoncés : ce sont son épaisseur et la résistivité au niveau de sa portion supérieure. Ainsi, selon ladite variante de réalisation, une interface rugueuse est présente entre le substrat de base 1 et la couche épitaxiée 2 ; la surface de la portion supérieure de la couche épitaxiée 2, à l'issue de son élaboration, présente une rugosité de l'ordre de grandeur de celle du substrat de base 1.

Le procédé de fabrication comprend également une étape c) de dépôt de la couche de piégeage de charges 3 sur la couche épitaxiée 2. Pour cela une technique connue de l'état de la technique peut être utilisée : par exemple, un dépôt chimique en phase vapeur (CVD) à pression atmosphérique, à une température comprise entre 900°C et 1100°C, sur un oxyde natif (non représenté) présent sur la couche épitaxiée 2. La présence de cet oxyde natif procure la structure polycristalline de la couche de piégeage 3. Alternativement, la couche de piégeage 3 peut être déposée par une technique de dépôt chimique en phase vapeur à pression réduite (LPCVD) à une température comprise entre 600°C et 850°C.

Avantageusement, les étapes b) et c) sont réalisées in situ, dans un même équipement (réacteur d'épitaxie). Dans ce cas, une très fine couche d'oxyde de silicium (non représenté) est déposée sur la couche épitaxiée 2 préalablement au dépôt de la couche de piégeage de charges 3, toujours dans le but de garantir la structure poly-cristalline de la couche de piégeage 3. L'élaboration in situ des deux couches 2,3 présente l'avantage d'éviter toute contamination au bore de l'interface entre ces couches, du fait de la mise en contact de la couche épitaxiée 2 avec l'atmosphère de la salle blanche. La haute résistivité de la portion supérieure de la couche épitaxiée 2 et de la couche de piégeage 3 n'est ainsi pas impactée négativement par la présence de traces de dopants (bore).

Lorsque la variante de réalisation utilisant le substrat de base 1 rugueux est mise en œuvre, il existe une zone rugueuse entre la couche épitaxiée 2 et la couche de piégeage de charges 3, ou plus spécifiquement, il existe une interface rugueuse entre la couche épitaxiée 2 et l'oxyde de silicium, et entre ce dernier et la couche de piégeage de charges 3. La surface de la couche de piégeage 3 est elle aussi rugueuse à l'issue de l'étape c).

L'étape c) est donc suivie d'un polissage mécano-chimique de la couche de piégeage de charges 3, de façon à obtenir une rugosité de surface du substrat support 10 inférieure ou égale à 1nm RMS, voire inférieure à 0,5nm RMS. Cette rugosité est requise notamment pour que le substrat support 10 soit compatible avec les procédés de transfert de la couche utile 30 de la structure SOI 100.

Notons qu'un polissage mécano-chimique peut également être appliqué en dehors de la mise en œuvre de la variante de réalisation utilisant le substrat de base 1 rugueux.

Selon un mode de mise en œuvre avantageux, le procédé de fabrication comprend une séquence de conception préalablement à l'étape a) ou à l'étape b). Cette séquence comporte :

i) la définition de la valeur maximale de distorsion de deuxième harmonique HD2 visée pour l'application radiofréquence,

ii) le choix de l'épaisseur de la couche épitaxiée 2 et de la résistivité du substrat de base 1 dans la plage [250ohm.cm - 500ohm.cm], à partir d'abaques reliant un facteur de qualité QF, représentatif de la distorsion de deuxième harmonique HD2, à l'épaisseur de la couche épitaxiée 2, pour une résistivité donnée du substrat de base 1 et pour une épaisseur donnée de la couche de piégeage 3.

La distorsion de deuxième harmonique HD2 est un paramètre critique bien connu pour les applications RF et peut être évaluée à partir d'une structure test de type lignes coplanaires (« coplanar waveguide ») élaborée sur le substrat support 10, en appliquant un signal d'entrée de puissance 15dBm avec une fréquence de 900MHz. Elle s'exprime en dBm. Les applications RF visent par exemple une valeur maximale HD2 de -80dBm ou de -90dBm, ou encore de -100dBm pour les plus exigeantes, avec une puissance d'entrée du signal RF de 15dBm.

Le facteur de qualité QF, représentatif de la distorsion de deuxième harmonique HD2, est décrit dans le document FR2985812 (ou US2015168326 de la même famille). Le contenu de ce document est incorporé ici par référence. Nous rappelons que le facteur de qualité est défini comme :

$$QF = A * \ln\left(\int_0^D \sigma(x).e^{\frac{-x}{L}}.dx\right) + B$$

Où D est la profondeur d'intégration (qui est au moins supérieure à cinq fois la longueur L), $\sigma(x)$ est la conductivité électrique mesurée à la profondeur x du substrat, L est une longueur caractéristique d'atténuation du champ électrique dans le substrat, A et B sont des coefficients empiriques.

La figure 4 démontre la corrélation entre le facteur de qualité QF exprimé en dBm, et le paramètre HD2 également exprimé en dBm et mesuré sur des composants tests. Il apparaît clairement que le facteur de qualité QF, qui ne nécessite pas la fabrication de dispositifs mais uniquement une mesure de résistivité en profondeur du substrat support 10, est très bien corrélé au paramètre HD2 et beaucoup plus simple à mesurer.

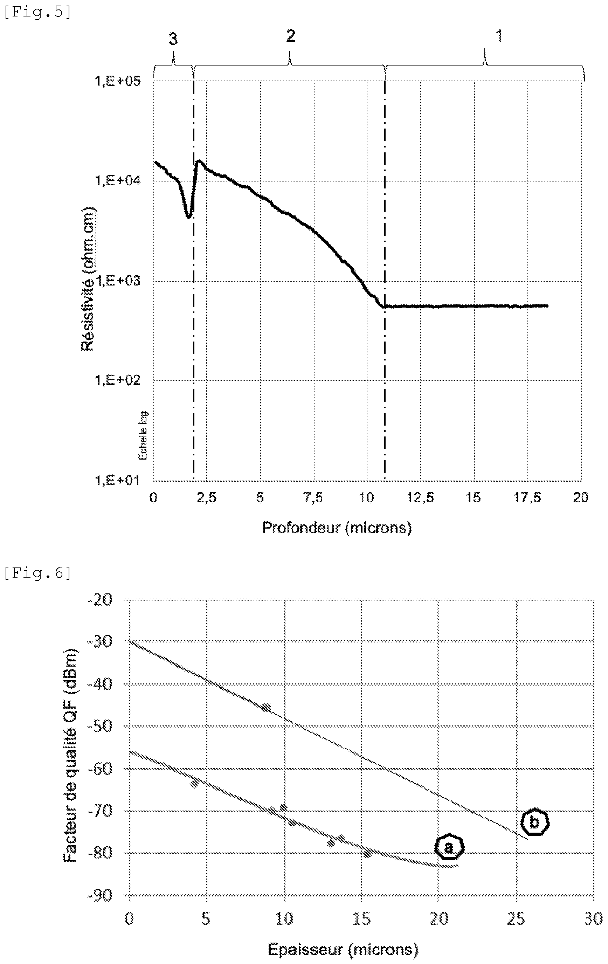

Dans la présente invention, le facteur de qualité QF est estimé à partir du profil de résistivité (reliée à la conductivité électrique $\sigma(x)$) en profondeur du substrat support 10 (et en particulier de la couche épitaxiée 2), dont un exemple est donné sur la figure 5. Un tel profil peut notamment être mesuré par SRP (du terme anglosaxon « Spreading Resistance Profile ») sur une partie chanfreinée du substrat support 10, donnant accès à une mesure dans l'épaisseur.

On peut remarquer que le profil de résistivité de la couche épitaxiée 2 augmente continument de sa portion inférieure (du côté du substrat de base 1) vers sa portion supérieure (du côté de la couche de piégeage de charges 3). Ce phénomène est connu dans le cas d'une épitaxie sur un substrat de base 1 comprenant des dopants de type P (bore), comme c'est ici le cas. Le bore en surface du substrat 1 est évaporé et condensé au cours de l'épitaxie ; puis progressivement dilué au fur et à mesure de l'épaississement de la couche épitaxiée 2, ce qui permet une augmentation continue de la résistivité de ladite couche 2. Le profil de résistivité croissante de la couche épitaxiée 2 dépend essentiellement du réacteur d'épitaxie utilisé et de la résistivité du substrat de base 1.

Dans l'exemple de la figure 5, représentatif d'un certain réacteur, le substrat de base présente une résistivité de 450ohm.cm ; la couche épitaxié 2 présente une épaisseur d'environ 10 microns et sa portion supérieure (entre environ 2 microns et environ 7 microns de profondeur sur le graphe) présente une résistivité comprise entre 3000 ohm.cm et 15000ohm.cm environ (en ordonnées logarithmiques).

La figure 6 montre un abaque reliant ledit facteur de qualité QF et l'épaisseur de la couche épitaxiée 2, pour une couche de piégeage 3 de 2 microns d'épaisseur et pour deux résistivités du substrat de base 1 : (a) une résistivité de 450 ohm.cm conforme à l'invention, et (b) une résistivité de 10 ohm.cm hors de la présente invention. Les courbes sont des simulations du paramètre QF, basées sur l'observation par la demanderesse que les profils de résistivité croissante de la couche épitaxiée 2 sont superposables pour les épaisseurs d'intérêt (comprises entre 2 et 30 microns) ; cela bien sûr pour une résistivité donnée du substrat de base 1 et dans un réacteur donné. Il est donc possible à partir d'un profil mesuré, par exemple pour une épaisseur de couche épitaxiée 2 supérieure à 10 microns, de simuler/extrapoler les profils de résistivité croissante pour les épaisseurs comprises entre 2 et 30 microns. Le facteur de qualité QF est alors calculé à partir des profils simulés pour chaque épaisseur de couche épitaxiée 2, donnant lieu à des abaques tels que celui présenté en figure 6. Notons que les points sur les courbes de la figure 6 correspondent à des mesures expérimentales venant conforter les simulations.

Dans cet exemple, pour un facteur de qualité QF à -80dBm (correspondant à une valeur maximale de HD2 sensiblement égale à -80dBm), l'épaisseur de la couche épitaxiée 2 du substrat support 10 doit être supérieure à 15 microns, typiquement comprise entre 15 microns et 18 microns. On observe qu'il faudrait une épaisseur de l'ordre de 30 microns voire supérieure dans le cas (b) où le substrat de base 1 a une faible résistivité, ce qui n'apparait pas économiquement viable.

Selon le niveau de performance souhaité pour les dispositifs RF (par exemple, une valeur maximale de HD2 à -70dBm, -80dBm ou - 90dBm... pour une puissance d'entrée du signal RF de 15dBm), il est donc possible d'ajuster l'épaisseur de la couche épitaxiée 2, ainsi que l'épaisseur de la couche de piégeage 3 et la résistivité du substrat de base 1 du substrat support 10 selon l'invention, en se basant sur des abaques. Ces trois paramètres sont définis en combinaison et ajustés les uns par rapport aux autres, de sorte que le substrat support 10 garantisse les performances RF des dispositifs.

Les caractéristiques physiques et électriques du substrat support 10 peuvent ainsi être définies au plus juste pour répondre à l'application RF visée, et apporter un bon compromis entre les performances RF et les coûts / la complexité de fabrication du substrat support 10.

Bien sûr, l'invention n'est pas limitée aux modes de réalisation décrits et on peut y apporter des variantes de réalisation sans sortir du cadre de l'invention tel que défini par les revendications.

En particulier, la couche utile 30 utilisée pour l'élaboration des dispositifs a été décrite dans le cadre d'une structure SOI, donc constituée de silicium ; mais il est tout à fait envisageable que la couche utile 30 comprenne d'autres types de matériaux, semi-conducteurs ou pas. De même, la couche diélectrique 20 peut comprendre différents types de matériaux isolants électriques.

**Revendications**

1. Substrat support (10) pour une application radiofréquence comprenant :

    - un substrat de base (1) en silicium monocristallin comprenant des dopants de type P et présentant une résistivité supérieure ou égale à 250 ohm.cm et strictement inférieure à 500 ohm.cm, et une teneur en oxygène interstitiel comprise entre 13 ppma et 19 ppma selon la norme ASTM'79,
    - une couche épitaxiée (2) en silicium monocristallin comprenant des dopants de type P, disposée sur le substrat de base (1) et présentant une épaisseur comprise entre 2 microns et 30 microns, une portion supérieure au moins de la couche épitaxiée présentant une résistivité supérieure ou égale à 3000 ohm.cm,
    - une couche de piégeage de charges (3) en silicium poly-cristallin, disposée sur la couche épitaxiée (2), présentant une résistivité supérieure ou égale à 1000 ohm.cm et une épaisseur comprise entre 1 micron et 10 microns.

2. Substrat support (10) pour une application radiofréquence selon la revendication précédente, dans lequel la résistivité du substrat de base (1) est inférieure ou égale à 450 ohm.cm.

3. Substrat support (10) pour une application radiofréquence selon l'une des revendications précédentes, dans lequel la couche épitaxiée (2) présente une épaisseur comprise entre 2 microns et 20 microns.

4. Substrat support (10) pour une application radiofréquence selon l'une des revendications précédentes, comprenant au moins une interface rugueuse entre le substrat de base (1) et la couche épitaxiée (2) et/ou entre la couche épitaxiée (2) et la couche de piégeage de charges (3).

5. Structure silicium sur isolant (100) comprenant une couche utile (30) disposée sur une couche diélectrique (20), elle-même disposée sur un substrat support (10) selon l'une des revendications précédentes.

6. Dispositif électronique pour application radiofréquence comprenant au moins un transistor disposé sur et/ou dans la couche utile (30) d'une structure silicium sur isolant (100) selon la revendication précédente.

7. Procédé de fabrication d'un substrat support (10) selon l'une des revendications précédentes, le procédé de fabrication comprenant les étapes suivantes :

    a) la fourniture du substrat de base (1),
    b) la croissance par épitaxie d'une couche en silicium monocristallin sur le substrat de base (1), pour former la couche épitaxiée (2),
    c) le dépôt de la couche de piégeage de charges (3) sur la couche épitaxiée.

8. Procédé de fabrication selon la revendication précédente, dans lequel :

    - le substrat de base (1) fourni à l'étape a) présente une rugosité de surface supérieure à 10nm RMS, voire supérieure à 100nm RMS, voire supérieure à 1 micron RMS, et
    - l'étape c) est suivie d'un polissage mécano-chimique de la couche de piégeage de charges (3), de manière à obtenir une rugosité de surface du substrat support (10) inférieure ou égale à 1nm du côté de sa face avant (10a).

9. Procédé de fabrication selon l'une des revendications 7 et 8, dans lequel les étapes b) et c) sont réalisées in situ, dans un même équipement, une couche d'oxyde de silicium étant déposée sur la couche épitaxiée préalablement au dépôt de la couche de piégeage de charges (3).

10. Procédé de fabrication selon l'une des revendications 7 à 9, comprenant une séquence de conception préalablement à l'étape a) ou à l'étape b) comportant :

    i) la définition de la valeur maximale de distorsion de deuxième harmonique (HD2) visée pour l'application radiofréquence,
    ii) le choix de l'épaisseur de la couche épitaxiée (2) et de la résistivité du substrat de base (1), à partir d'abaques reliant un facteur de qualité (QF), représentatif de la distorsion de deuxième harmonique (HD2), à l'épaisseur de la couche épitaxiée (2), pour une résistivité donnée du substrat de base (1) et pour une épaisseur donnée de la couche de piégeage (3).

**Patentansprüche**

1. Trägersubstrat (10) für eine Hochfrequenzanwendung, umfassend:

    - ein Basissubstrat (1) aus monokristallinem Silizium, das P-Typ-Dotierstoffe umfasst und einen spezifischen Widerstand von größer oder gleich 250 Ohm.cm und strikt kleiner als 500 Ohm.cm und einen Gehalt an interstitiellem Sauerstoff zwischen 13 ppma und 19 ppma gemäß der Norm ASTM'79 aufweist,
- eine durch Epitaxie gebildete Schicht (2) aus monokristallinem Silizium, die P-Typ-Dotierstoffe umfasst, die auf dem Basissubstrat (1) angeordnet ist und eine Dicke zwischen 2 Mikron und 30 Mikron aufweist, wobei mindestens ein oberer Abschnitt der durch Epitaxie gebildeten Schicht einen spezifischen Widerstand von 3000 Ohm.cm oder höher aufweist,
- eine auf der durch Epitaxie gebildeten Schicht (2) angeordnete Ladungsfangschicht (3) aus polykristallinem Silizium, die einen spezifischen Widerstand von 1000 Ohm.cm oder mehr und eine Dicke zwischen 1 Mikron und 10 Mikron aufweist.

2. Trägersubstrat (10) für eine Hochfrequenzanwendung nach dem vorstehenden Anspruch, wobei der spezifische Widerstand des Basissubstrats (1) kleiner oder gleich 450 Ohm.cm ist.

3. Trägersubstrat (10) für eine Hochfrequenzanwendung nach einem der vorstehenden Ansprüche, wobei die durch Epitaxie gebildete Schicht (2) eine Dicke zwischen 2 Mikron und 20 Mikron aufweist.

4. Trägersubstrat (10) für eine Hochfrequenzanwendung nach einem der vorstehenden Ansprüche, umfassend mindestens eine raue Grenzfläche zwischen dem Basissubstrat (1) und der durch Epitaxie gebildeten Schicht (2) und/oder zwischen der durch Epitaxie gebildeten Schicht (2) und der Ladungsfangschicht (3).

5. Silicon-on-Insulator-Struktur (100), umfassend eine Nutzschicht (30), die auf einer dielektrischen Schicht (20) angeordnet ist, die ihrerseits auf einem Trägersubstrat (10) nach einem der vorstehenden Ansprüche angeordnet ist.

6. Elektronische Vorrichtung für Hochfrequenzanwendungen, die mindestens einen Transistor umfasst, der auf und/oder in der Nutzschicht (30) einer Silicon-on-Insulator-Struktur (100) nach dem vorstehenden Anspruch angeordnet ist.

7. Verfahren zur Herstellung eines Trägersubstrats (10) nach einem der vorstehenden Ansprüche, wobei das Herstellungsverfahren die folgenden Schritte umfasst:

   a) Bereitstellen des Basissubstrats (1),
   b) epitaktisches Züchten einer Schicht aus monokristallinem Silizium auf dem Basissubstrat (1), um die durch Epitaxie gebildete Schicht (2) zu bilden,
   c) Aufbringen der Ladungsfangschicht (3) auf die durch Epitaxie gebildeten Schicht.

8. Herstellungsverfahren nach dem vorstehenden Anspruch, wobei:

   - das in Schritt a) bereitgestellte Basissubstrat (1) eine Oberflächenrauheit von mehr als 10 nm RMS, sogar mehr als 100 nm RMS oder sogar mehr als 1 Mikron RMS aufweist, und
   - auf Schritt c) ein chemisch-mechanisches Polieren der Ladungsfangschicht (3) folgt, sodass eine Oberflächenrauheit des Trägersubstrats (10) von weniger als oder gleich 1 nm auf der Seite seiner Vorderseite (10a) erhalten wird.

9. Herstellungsverfahren nach einem der Ansprüche 7 und 8, wobei die Schritte b) und c) in situ in derselben Anlage ausgeführt werden, wobei eine Siliziumoxidschicht auf der durch Epitaxie gebildeten Schicht vor dem Aufbringen der Ladungsfangschicht (3) aufgebracht wird.

10. Herstellungsverfahren nach einem der Ansprüche 7 bis 9, umfassend eine Entwurfssequenz vor Schritt a) oder Schritt b), die umfasst:

   i) Definieren des für die Hochfrequenzanwendung angestrebten Höchstwertes für die Verzerrung der zweiten Harmonischen (HD2),
   ii) Wählen der Dicke der durch Epitaxie gebildeten Schicht (2) und des spezifischen Widerstands des Basissubstrats (1) anhand von Diagrammen, die einen Gütefaktor (QF), der die Verzerrung der zweiten Harmonischen (HD2) darstellt, mit der Dicke der der durch Epitaxie gebildeten Schicht (2) bei einem gegebenen spezifischen Widerstand des Basissubstrats (1) und bei einer gegebenen Dicke der Fangschicht (3) in Beziehung setzen.

## Claims

1. Support substrate (10) for a radiofrequency application, the support substrate comprising:

   - a base substrate (1) made of monocrystalline silicon comprising P-type dopants and having a resistivity that is greater than or equal to 250 ohm.cm and strictly less than 500 ohm.cm, and an interstitial oxygen content between 13 ppma and 19 ppma according to the ASTM'79 standard,
   - an epitaxial layer (2) made of monocrystalline silicon comprising P-type dopants, arranged on the base substrate (1) and having a thickness between 2 microns and 30 microns, at least one upper portion of the epitaxial layer having a resistivity greater than or equal to 3000 ohm.cm,
- a charge-trapping layer (3) made of polycrystalline silicon, arranged on the epitaxial layer (2), having a resistivity greater than or equal to 1000 ohm.cm and a thickness between 1 micron and 10 microns.

2. Support substrate (10) for a radiofrequency application according to the preceding claim, wherein the resistivity of the base substrate (1) is less than or equal to 450 ohm.cm.

3. Support substrate (10) for a radiofrequency application according to either of the preceding claims, wherein the epitaxial layer (2) has a thickness between 2 microns and 20 microns.

4. Support substrate (10) for a radiofrequency application according to any of the preceding claims, comprising at least one rough interface between the base substrate (1) and the epitaxial layer (2) and/or between the epitaxial layer (2) and the charge-trapping layer (3).

5. Silicon-on-insulator structure (100) comprising a useful layer (30) arranged on a dielectric layer (20), itself arranged on a support substrate (10) according to any of the preceding claims.

6. Electronic device for radiofrequency application comprising at least one transistor arranged on and/or in the useful layer (30) of a silicon-on-insulator structure (100) according to the preceding claim.

7. Method for producing a support substrate (10) according to any of the preceding claims, the production method comprising the following steps:

   a) providing the base substrate (1),
   b) epitaxially growing a layer made of monocrystalline silicon on the base substrate (1), in order to form the epitaxial layer (2),
   c) depositing the charge-trapping layer (3) on the epitaxial layer.

8. Production method according to the preceding claim, wherein:

   - the base substrate (1) provided in step a) has a surface roughness greater than 10 nm RMS, or even greater than 100 nm RMS, or even greater than 1 micron RMS, and
   - step c) is followed by chemical-mechanical polishing of the charge-trapping layer (3), so as to obtain a surface roughness of the support substrate (10) less than or equal to 1 nm on the side of the front face (10a) thereof.

9. Production method according to either claim 7 or claim 8, wherein steps b) and c) are carried out in situ, in the same apparatus, a layer of silicon oxide being deposited on the epitaxial layer prior to the deposition of the charge-trapping layer (3).

10. Production method according to any of claims 7 to 9, comprising a design sequence prior to step a) or step b), including:

   i) defining the maximum second harmonic distortion value (HD2) considered for the radiofrequency application,
   ii) choosing the thickness of the epitaxial layer (2) and the resistivity of the base substrate (1), from charts connecting a quality factor (QF), representative of the second harmonic distortion (HD2), to the thickness of the epitaxial layer (2), for a given resistivity of the base substrate (1) and for a given thickness of the trapping layer (3).

[Fig.1]

[Fig.2]

[Fig.3]

[Fig.4]

[Fig.5]

[Fig.6]

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2018114720 A
- US 20200126847 A1
- FR 2985812
- US 2015168326 A

**Littérature non-brevet citée dans la description**

- **OLEG KONONCHUK** ; **BICH-YEN NGUYEN**. Silicon-on-insulator (SOI) Technology, manufacture and applications. Woodhead Publishing